Europäisches Patentamt

European Patent Office

Office européen des brevets

(19)

(11) Veröffentlichungsnummer: **0 011 110**
**B1**

(12) # EUROPÄISCHE PATENTSCHRIFT

(45) Veröffentlichungstag der Patentschrift:
29.12.82

(51) Int. Cl.³: **G 01 R 15/07**

(21) Anmeldenummer: 79103626.2

(22) Anmeldetag: 24.09.79

(54) **Anordnung zur elektrooptischen Spannungsmessung.**

(30) Priorität: 19.10.78 DE 2845625

(43) Veröffentlichungstag der Anmeldung:
28.05.80 Patentblatt 80/11

(45) Bekanntmachung des Hinweises auf die Patenterteilung:
29.12.82 Patentblatt 82/52

(84) Benannte Vertragsstaaten:
BE CH FR GB SE

(56) Entgegenhaltungen:
CH-A-433 065
DE-A-1 591 976
DE-A-2 543 134
DE-B-2 010 978
DE-B-2 130 046
DE-B-2 131 224
US-A-4 002 975
US-A-4 117 399

(73) Patentinhaber: **SIEMENS AKTIENGESELLSCHAFT**
**Berlin und München, Postfach 22 02 61,**
**D-8000 München 22 (DE)**

(72) Erfinder: **Feldtkeller, Ernst, Prof. Dr.,**
**Michaeliburgstrasse 15, D-8000 München 80 (DE)**

## Anordnung zur elektrooptischen Spannungsmessung

Die Erfindung bezieht sich auf eine Anordnung zur elektrooptischen Spannungsmessung an einem Hochspannungsleiter, dessen elektrisches Feld einen linear oder zirkular polarisierten Lichtstrahl elliptisch polarisiert und bei der in einem Empfänger die zu messende Spannung aus der Phasendifferenz zwischen den mit verschiedenen Durchtrittsgeschwindigkeiten laufenden Komponenten der Lichtwelle abgeleitet wird, mit Leitungen für den polarisierten Lichtstrahl zwischen einem Kopfteil mit dem Hochspannungsleiter und einem Fußteil mit einem Sender und dem Empfänger.

Die Abhängigkeit der Doppelbrechung von einem äußeren elektrischen Feld wird bekanntlich als elektrooptischer Effekt bezeichnet. Ein linear oder zirkular polarisierter Lichtstrahl wird beim Durchtritt durch ein doppelbrechendes Medium im allgemeinen elliptisch polarisiert. Die den beiden Hauptachsen des doppelbrechenden Mediums zugeordneten Komponenten der Lichtwelle bewegen sich durch das Medium mit verschiedenen Geschwindigkeiten. Die resultierende Phasendifferenz ist proportional der vom Lichtstrahl im Kristall zurückgelegten Strecke und, wenn es sich um einen linearen elektrooptischen Effekt handelt und die Doppelbrechung ohne Feld verschwindet, zum elektrischen Feld. Sie kann zur Messung des Feldes und somit zur Spannungsmessung verwendet werden.

Es sind Verfahren zur Spannungsmessung bekannt, bei denen die elektrische Feldstärke E mit dem elektrooptischen Effekt in unsymmetrischen Kristallen oder mit Hilfe des Feldeinflusses auf Flüssigkristalle bestimmt wird. Dabei wird aber nur die elektrische Feldstärke in dem verhältnismäßig kleinen Kristallvolumen bestimmt. Aus der deutschen Auslegeschrift DE-AS 2 130 046 ist eine Anordnung zur elektrooptischen Spannungsmessung an einem Hochspannungsleiter, dessen elektrisches Feld einen linear oder zirkular polarisierten Lichtstrahl elliptisch polarisiert und der in einem Empfänger die zu messende Spannung aus der Phasendifferenz zwischen den mit verschiedenen Durchtrittsgeschwindigkeiten laufenden Komponenten der Lichtwelle abgeleitet wird, mit Leitungen für den polarisierten Lichtstrahl zwischen einem Kopfteil mit dem Hochspannungsleiter und einem Fußteil mit einem Sender und Empfänger bekannt. Bei dieser bekannten Anordnung werden als Meßfühler Spulen aus Lichtleitern verwendet, bei denen zudem sorgfältig darauf geachtet werden muß, daß diese Lichtleiter nur in Querrichtung von dem elektrischen Feld beeinflußt werden. Bei dieser bekannten Anordnung dienen die Leitungen für den polarisierten Lichtstrahl zwischen dem Kopfteil und dem Fußteil nur zur Übertragung des polarisierten Lichts, nicht jedoch zur Beeinflussung von polarisiertem Licht. Bei der bekannten Anordnung ist die Doppelbrechungseigenschaft der als Meßfühler verwendeten Lichtleiterspule in erster Linie auf die Krümmung der Lichtleitfasern zurückzuführen.

Die Aufgabe der Erfindung besteht nun darin, eine einfache und billige Meßanordnung anzugeben, bei der die Spannung U = ∫Edl über eine große Strecke l aufintegriert wird.

Diese Aufgabe wird erfindungsgemäß dadurch gelöst, daß als Leitungen für den polarisierten Lichtstrahl zwischen dem Kopfteil mit dem Hochspannungsleiter und dem Fußteil mit dem Sender und dem Empfänger wenigstens zwei Kristallfasern mit longitudinalem, linearem elektrooptischen Effekt vorgesehen sind, wobei jeweils zwei auf dem Weg des Lichtstrahls aufeinanderfolgende Faserenden fluchten und wobei die Kristallorientierungen von jeweils zwei auf dem Weg des Lichtstrahls aufeinanderfolgenden Kristallfasern gegeneinander um 90° gedreht sind. Am Hochspannungsleiter ist die Kristallfaser vorzugsweise so geführt, daß die Formdoppelbrechung innerhalb der Kristallfaser aufgehoben wird. Die Kristallachsen von jeweils zwei auf dem Weg des Lichtstrahls aufeinanderfolgenden Leitungen sind gegeneinander so orientiert, daß sich die Effekte der Doppelbrechung in den jeweiligen Leitungen addieren und die Phasenverschiebung über der gesamten Strecke aufintegriert werden kann. Die Messung mit dieser im elektrischen Feld doppelbrechenden Kristallfaser ist unabhängig von der Feldverteilung an dieser Strecke und sogar unabhängig vom Weg l der Faserführung. Die Doppelbrechung bei einer erfindungsgemäßen Kristallfaser ergibt sich aus deren Kristallstruktur. Diese Doppelbrechung bei einer solchen Kristallfaser wird erst durch das Anlegen eines äußeren elektrischen F< 'es hervorgerufen. Die Abhängigkeit der elektrisch erzeugten Doppelbrechung bei einer Kristallfaser vom äußeren elektrischen Feld ist gut bekannt. Bei einer erfindungsgemäßen Meßanordnung werden keine Faserspulen benötigt.

Als Strahlungsquelle ist im allgemeinen ein Laser mit vorgeschaltetem Polarisator vorgesehen. Zwischen Polarisator und Zuleitung wird zweckmäßig ein λ/4-Plättchen vorgesehen, welches die lineare Polarisation in eine zirkulare Polarisation umwandelt. In einem Kopfteil am Hochspannungsleiter ist ein Umlenkkörper vorgesehen, an dem die Kristallfaser in verschiedenen Teilstrecken in zueinander senkrechten Ebenen derart geführt wird, daß die durch die Faserkrümmung verursachte Formdoppelbrechung aufgehoben wird. Im Empfänger wird die Phasenverschiebung in eine entsprechende elektrische Größe umgesetzt, die als Maß für die Spannung dient.

In einer besonderen Ausführungsform der Meßanordnung ist der Empfänger mit einem Kompensator versehen, der die Doppelbrechung der Kristallfaser kompensiert. Er enthält ein elektrooptisches Material, das vorzugsweise schon bei sehr geringer Spannung doppelbrechend wirkt. Sein Ausgangssignal dient als Maß für die zu messende Spannung. Die Kompensatorspannung ist auch dann proportional zur Hochspannung, wenn die Phasenverschiebung $2\pi$ überschreitet.

Unter Umständen kann eine alternative Lösung darin bestehen, wenn wenigstens eine der Leitungen für den polarisierten Lichtstrahl zwischen dem Kopfteil und dem Fußteil der Anordnung aus der im elektrischen Feld doppelbrechenden Kristallfaser und wenigstens eine weitere dieser Leitungen aus einem nicht elektrooptisch wirksamen Lichtleiter, welcher auch eine Monomode-Faser oder eine Flüssigkernfaser sein kann, besteht.

Als Zuleitung kann auch eine depolarisierende Kristallfaser vorgesehen sein. In dieser Ausführungsform wird der Polarisator und vorzugsweise noch ein $\lambda/4$-Plättchen am Hochspannungsleiter angeordnet. Durch diesen Aufbau der Meßanordnung wird der Umlenkkörper vereinfacht.

In einer weiteren Ausführungsform der Anordnung zur elektrooptischen Spannungsmessung sind anstelle des Kompensators zur Phasendemodulation ein zweites Detektorsystem und eine Auswerteschaltung vorgesehen. Jedes der Detektorsysteme enthält jeweils ein Strahlteilerprisma und den Teilstrahlen zugeordnete Detektoren. Die Lichtwelle wird z. B. über einen halbdurchlässigen Spiegel auf die beiden Detektorsysteme verteilt. Dem ersten Detektorsystem kann vorzugsweise ein $\lambda/4$-Plättchen vorgeschaltet werden und die Strahlteilerprismen der beiden Detektorsysteme sind so orientiert, daß beim Verschwinden der zu messenden Spannung U die beiden Strahlintensitäten hinter dem ersten Strahlteilerprisma gleich groß sind, während hinter dem zweiten Strahlteilerprisma bei $U = 0$ nur ein Teilstrahl austritt.

Statt des halbdurchlässigen Spiegels kann auch noch ein zusätzliches Lichtleitersystem vorgesehen sein, dessen Ende mit dem Eingang des zweiten Detektorsystems optisch gekoppelt ist.

Eine Technik zum Ziehen der erforderlichen langen, dünnen Kristalle ist bekannt, beispielsweise aus dem »J. Mat. Sci.«, 7 (1972), Seiten 631, 649 und 787.

Da die Kristallfaser ohne elektrische Spannung nicht doppelbrechend sein soll, sind Materialien mit kubischer oder tetragonaler Kristallstruktur geeignet. Bei der tetragonalen Kristallstruktur muß die c-Achse parallel zur Faserachse liegen.

Ein longitudinaler elektrooptischer Effekt tritt in diesen Kristallsystemen auf, wenn der elektrooptische Koeffizient $r_{63}$ nicht verschwindet oder $r_{13} - r_{23} \neq 0$ ist. Dies ist bekanntlich der Fall in der Kristallklasse $T_d \equiv \overline{4}3$ m (Proc. IRE, 46 [1958], S. 764 bis 778, insbes. S. 768). Diese Eigenschaft haben beispielsweise die Zinkblende ZnS, die Kupferhalogenide CuF und CuCl u. a. und Eulytin $Bi_4(SiO_4)_3$. Ferner ist geeignet die Kristallklasse $T \equiv 23$, beispielsweise das Natriumchlorat $NaClO_3$, die Kristallklasse $D_{2d} = \overline{4}2$ m, beispielsweise das Kaliumdihydrogenphosphat $KH_2PO_4$ und der Harnstoff $CO(NH_2)_2$ und die Kristallklasse $S_4 \equiv \overline{4}$, beispielsweise Pentaerythrit $C(CH_2OH)_4$.

Beträgt der Brechungsindex für Licht, dessen elektrische Schwingung ($\hat{E}$-Vektor) senkrecht zur c-Achse liegt, ohne elektrisches Feld einheitlich $n_0$, d. h., er hat bei der Spannung Null keine Doppelbrechung, so entsteht für Materialien aus den Kristallklassen $T_d$, T oder $D_{2d}$ in einem parallel zur c-Achse liegenden elektrischen Feld $E_z$ eine Doppelbrechung mit den Brechungsindices

$$n_0 + \frac{n_0^3 r_{63} E_z}{2} \quad \text{bzw.}$$

$$n_0 - \frac{n_0^3 r_{63} E_z}{2}$$

für zwei senkrecht aufeinanderstehende Hauptachsenrichtungen in [110]- und [1$\overline{1}$0]-Richtung. Es entsteht somit eine Doppelbrechung von der Größe $n_0^3 r_{63} E_z$.

Bei der Kristallklasse $S_4$ überlagert sich diesem Effekt aufgrund der Koeffizienten $r_{13} = -r_{23} \neq 0$ eine Doppelbrechung mit [100]-Orientierung. Die Hauptachsen der resultierenden Doppelbrechung liegen deshalb zwischen den [100]- und [110]-Richtungen. Da das Vorzeichen der Doppelbrechung vom Vorzeichen der angelegten Spannung abhängt, kann dieser lineare Effekt zur Spannungsmessung herangezogen werden.

Zur weiteren Erläuterung der Erfindung wird auf die Zeichnung Bezug genommen, in deren Fig. 1 ein Ausführungsbeispiel einer Anordnung zur elektrooptischen Spannungsmessung an einem Hochspannungsleiter nach der Erfindung schematisch veranschaulicht ist. Die elliptische Polarisation durch die Doppelbrechung in einem Kristall ist anhand der Fig. 2 bis 4 erläutert. Fig. 5 zeigt eine besondere Ausführungsform der Meßanordnung mit zwei Detektorsystemen im Empfänger. In Fig. 6 ist eine Ausführungsform der Meßanordnung mit zwei verschiedenen Kristallfasern zur Kompensation der Temperaturabhängigkeit dargestellt. In Fig. 7 ist die Kompensation der Temperaturabhängigkeit durch verschiedene Kristallfasern in einem Diagramm veranschaulicht.

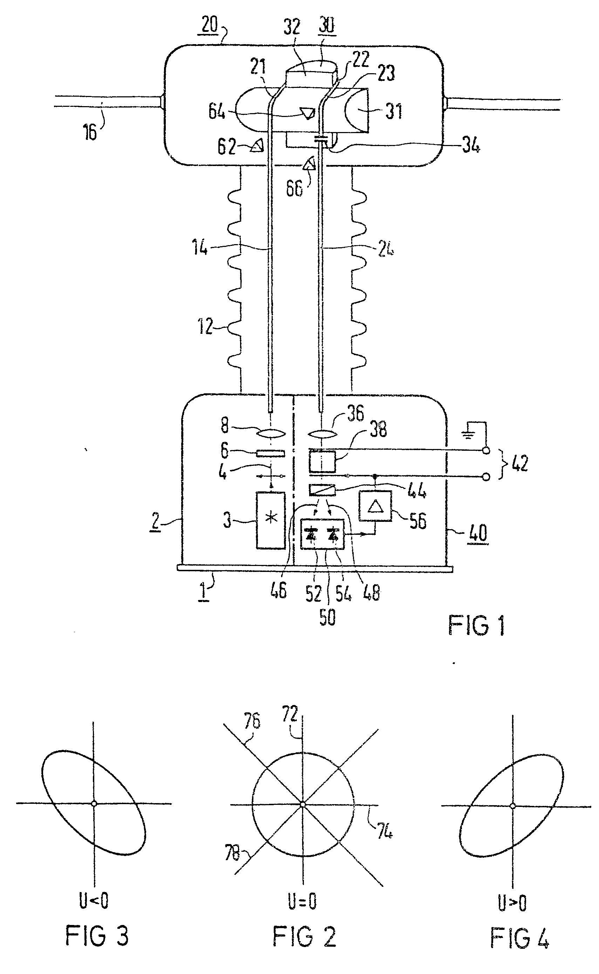

Nach Fig. 1 enthält ein Fußteil 1, das sich auf Nullpotential befindet, einen Sender 2 mit einer Lichtquelle 3, für einen polarisierten Lichtstrahl 4, einem $\lambda/4$-Plättchen 6 und einer Einkoppeloptik 8. In einem Isolator 12 ist eine lichtleitende Kristallfaser 14 angeordnet, die aus piezoelektrischem Material mit longitudinalem, linearem elektrooptischen Effekt besteht und den Lichtstrahl 4 zu einem Kopfteil 20 führt, das sich an einem Hochspannungsleiter 16 mit einer Spannung von beispielsweise wenigstens 220 kV befindet. Das Kopfteil 20 enthält einen Umlenkkörper 30, der aus zwei halbkreiszylindrischen Segmenten 31 und 32 besteht. Er dient zur Führung der Kristallfaser in mehreren Teilwindungen 21, 22 und 23. Zwischen der Kristallfaser 14 und der lichtleitenden Kristallfaser 24 ist eine nicht näher dargestellte optische Kupplungseinrichtung 34 vorgesehen.

Am Ende der Kristallfaser 24 ist im Fußteil 1 ein Empfänger 40 angeordnet, der eine Auskopplungsoptik 36 für den Lichtstrahl 4 enthält und mit einem Kompensator 38 versehen ist, an dessen elektrischem Ausgang 42 der Meßwert abgenommen werden kann. Dem Kompensator 38 ist ein Strahlteiler 44 nachgeordnet, der beispielsweise ein Wollastonprisma sein kann und den empfangenen Lichtstrahl in senkrecht zueinander polarisierte Teilstrahlen 46 und 48 aufteilt. Eine Detektoranordnung 50 enthält für die beiden Teilstrahlen jeweils einen Detektor 52 bzw. 54 sowie einen Differenzverstärker, dessen Ausgangssignal über einen Verstärker 56, vorzugsweise einen Leistungsverstärker, dem Kompensator 38 zugeführt wird.

Die Lichtquelle 3 liefert den gebündelten Lichtstrahl 4 linear polarisierten Lichts, was oberhalb der Lichtquelle 2 durch einen nicht näher bezeichneten Doppelpfeil angedeutet ist. Der Lichtquelle 3 kann unter Umständen noch ein in der Figur nicht dargestellter Polarisator nachgeordnet sein. Das $\lambda/4$-Plättchen 6 wandelt das linear polarisierte Licht der Lichtquelle 3 um in zikular polarisiertes Licht. Die optischen Achsen des $\lambda/4$-Plättchens 6 sind deshalb gegenüber der Polarisationsrichtung des von der Lichtquelle 3 gelieferten Lichtstrahls 4 jeweils um 45° gedreht. Der zirkular polarisierte Lichtstrahl 4 wird über die Einkopplungsoptik 8, die beispielsweise als Sammellinse dargestellt ist, in die Kristallfaser eingekoppelt. Die Kristallfaser 14 durchläuft eine Strecke zwischen der Lichtquelle 3 und dem Hochspannungsleiter 16, dessen Spannung gemessen werden soll. Über diese Strecke soll die Spannung des Hochspannungsleiters 16 mit der Meßanordnung nach der Erfindung aufintegriert werden.

Die Kristallfaser 14 wirkt wie jeder Lichtleiter auch ohne elektrisches Feld doppelbrechend, sobald sie gekrümmt wird. Eine Krümmung läßt sich zwischen der Zuleitung 14 und der Rückleitung 24 nicht vermeiden. Gemessen werden soll aber nur die von der Spannung des Hochspannungsleiters 16 verursachte Doppelbrechung. Die Kristallfaser 14 wird deshalb auf dem Umlenkkörper 30 an den Segmenten 31 und 32 so geführt, daß die auf der Faserkrümmung beruhende Formdoppelbrechung kompensiert wird, wie es beispielsweise in der deutschen Offenlegungsschrift Nr. 2 543 134 für eine Einrichtung zur Strommessung durch Ermittlung der Faraday-Drehung im Magnetfeld des stromführenden Leiters beschrieben ist. An den Segmenten 31 und 32 des Umlenkkörpers 30 bildet die Kristallfaser zwei Viertelwindungen 21 und 23 in senkrechter Richtung, denen eine Halbwindung 22 in horizontaler Richtung zugeordnet ist. Durch diese Führung der Kristallfaser wird die innerhalb der Faser durch die Krümmung verursachte Doppelbrechung aufgehoben und es entsteht somit keine zusätzliche Doppelbrechung.

Die Kristallfasern 14 und 24 haben die Eigenschaft, daß sie im elektrischen Feld doppelbrechend wirken. Dies hat zur Folge, daß eine Komponente der Lichtwelle des Lichtstrahls 4 mit einer bestimmten Polarisationsebene in den Kristallfasern 14 bzw. 24 eine höhere Durchtrittsgeschwindigkeit hat als die zweite Komponente mit dazu senkrechter Polarisation. Durch die verschiedenen Geschwindigkeiten der Komponenten mit zueinander senkrechten Polarisationsrichtungen erhält man am Ende der Faser 24 die Phasenverschiebung, die als Maß für die zu messende Spannung im Hochspannungsleiter 16 dient.

In der Kupplungseinrichtung 34 wird die Lichtwelle des Lichtstrahls 4 in die als Rückleitung 24 dienende zweite Kristallfaser derart eingekoppelt, daß die Kristallorientierung der Faser 24 gegenüber der Kristallfaser 14 um 90° gedreht ist.

Die Orientierung der Kristallstrukturelemente der Faser 14 ist in der Figur durch ein Tetraeder 62 angedeutet. Das Tetraeder stellt z. B. die Anordnung der vier Schwefelatome in der Umgebung eines Zinkatoms in der Zinkblende ZnS dar. Die Änderung der Kristallorientierung durch die Führung der Kristallfaser am Umlenkkörper 30 ist durch ein weiteres Tetraeder 64 veranschaulicht. Durch die Kupplungseinrichtung 34 wird dann die Kristallachse um 90° gedreht, so daß die Rückleitung 24 wieder die gleiche Kristallorientierung wie die Zuleitung 14 erhält und sich dadurch die Effekte der Doppelbrechung in der Zuleitung 14 und der Rückleitung 24 addieren. Die Kristallorientierung der Rückleitung 24 ist durch ein weiteres Tetraeder 66 veranschaulicht. Durch die Kupplungseinrichtung 34 erhält man somit zwei verschiedene Fasern, welche die Addition der Doppelbrechung ermöglichen. Die Phasenverschiebung der beiden Polarisationsrichtungen ist proportional der Spannung im Hochspannungsleiter 16 und damit ein Maß für die zu messende Spannung.

Die Hauptachsen 72 und 74 der Doppelbrechung verlaufen nach Figur 2 senkrecht bzw. waagerecht. Bei der zu messenden Spannung U = 0 haben die in den beiden Hauptachsen polarisierten Lichtwellen gleiche Geschwindigkeit. Infolgedessen ist der Lichtstrahl auch am Ende der Faser 24 noch zirkular polarisiert, und die beiden Detektoren 52 und 54 des Empfängers 40 nach Figur 1 erhalten Teilstrahlen 46 bzw. 48 gleicher Intensität. Das Ausgangssignal des Detektors 50 ist Null und der Verstärker 56 liefert kein Signal. Mit zunehmender Spannung und damit zunehmender Phasendifferenz entsteht am Ende der Rückleitung 24 eine elliptische Polarisation des Lichtstrahls, wobei die Orientierung der großen Achse der Ellipse vom Vorzeichen der zu messenden Spannung im Hochspannungsleiter 16 abhängt. Ist die Spannung U < 0, so resultiert nach Figur 3 in der ersten Faserkristallachse 76 eine größere Amplitude als in der zweiten Faserkristallachse 78. Ist dagegen die Spannung U > 0, so

4

resultiert nach Figur 4 in der zweiten Faserkristallachse eine größere Amplitude als in der ersten.

Solange der Kompensator 38 diese Elliptizität nicht kompensiert, liefert der Verstärker 56 ein Signal, dessen Vorzeichen durch das Vorzeichen der zu messenden Spannung im Hochspannungsleiter 16 bestimmt wird. Wenn der Verstärkungsfaktor des Verstärkers 56 genügend groß ist, wird die Phasenverschiebung durch den Kompensator 38 kompensiert. Die Kompensatorspannung folgt dadurch Änderungen der zu messenden Spannung, und zwar auch wenn die Phasenverschiebung mehr als 360° beträgt. Die Detektorschaltung 50 im Empfänger 40 muß dazu so schnell sein, daß sie den auftretenden Phasenverschiebungen laufend folgen kann und verhindert wird, daß ganze Vielfache von 360° nicht registriert werden. Die am Kompensator 38 anliegende Spannung ist proportional der Spannung an den Kristallfasern 14 und 24 und kann somit am Ausgang 42 als Maß für die zu messende Spannung im Hochspannungsleiter 16 verwendet werden.

Wenn auch im Kompensator 38 ein longitudinaler elektrooptischer Effekt ausgenutzt wird, ist das Verhältnis der Wandlerausgangsspannung zur zu messenden Spannung im Leiter 16 doppelt so groß wie das Verhältnis der Halbwellenspannungen des Kompensator- und Fasermaterials.

Anstelle der beiden Kristallfasern mit elektrooptischem Effekt für die Zuleitung 14 und die Rückleitung 24 kann auch nur eine der beiden Leitungen, vorzugsweise die Rückleitung 24, aus einem elektrooptisch wirksamen Faserkristall bestehen. Die Zuleitung 14 besteht dann aus einer nicht depolarisierenden aber elektrooptisch unwirksamen Lichtleitfaser, beispielsweise einer Monomodefaser oder auch einer Flüssigkernfaser.

Ferner kann es zweckmäßig sein, für die Zuleitung 14 eine depolarisierende Lichtleitfaser, beispielsweise eine gewöhnliche Multimodefaser zu verwenden. Die Rückleitung 24 besteht dann aus einer Kristallfaser mit elektrooptischem Effekt. Ein Polarisator sowie eine Einkopplungseinrichtung und ein $\lambda$/4-Plättchen zur Erzeugung des zirkular polarisierten Lichtes sind dann vorzugsweise im Kopfteil 20 am Hochspannungsleiter 16 angeordnet. In dieser Ausführungsform kann man einen wesentlich einfacheren Umlenkkörper verwenden, weil lediglich eine Halbwindung zwischen der Zuleitung 14 und der Rückleitung 24 erforderlich ist.

Das Zusammensetzen der Meßanordnung am Einsatzort kann man dadurch vereinfachen, daß im Wege der Fasern zusätzliche in den Figuren nicht dargestellte Kupplungen vorgesehen sind. In dieser Ausführungsform müssen dann nur die im Stützerisolator 12 verlaufenden Lichtleiterabschnitte der Rückleitung und evtl. auch der Zuleitung aus Kristallfasern bestehen, während die Lichtleiter in den feldfreien Räumen des Kopfteiles und des Fußteiles elektrooptisch unwirksame Glas- bzw. Flüssigkern-Lichtleiter sein können.

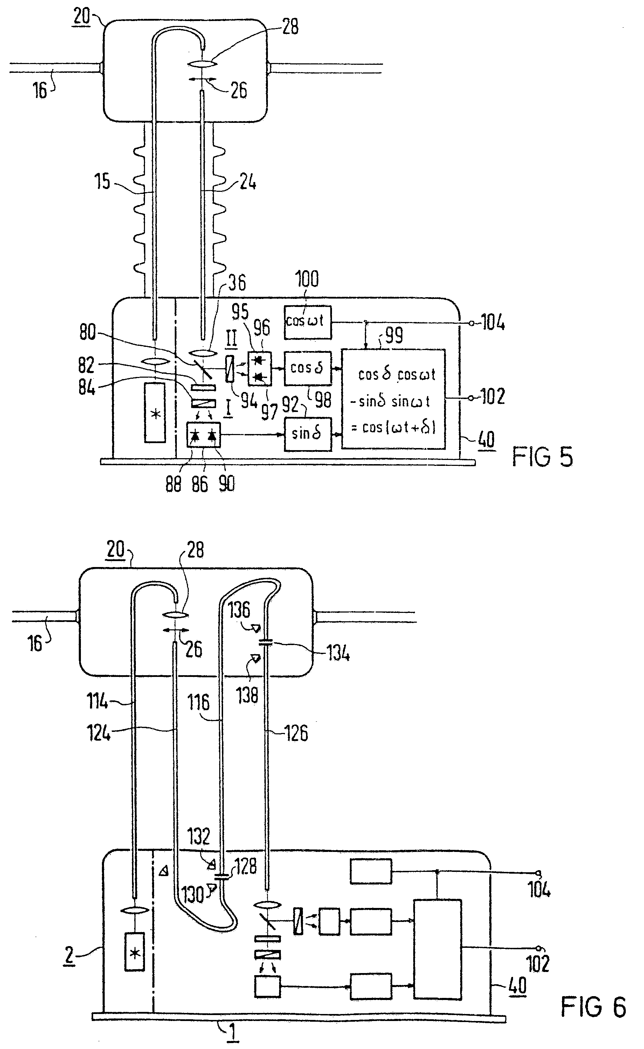

In der Ausführungsform der Meßanordnung nach Fig. 5 mit einer depolarisierenden Lichtleitfaser als Zuleitung 15, einem einfachen, in der Figur nicht dargestellten Umlenkkörper, sowie einem im Kopfteil 20 angeordneten Polarisator 26 und einer Einkopplungseinrichtung 28 ist außerdem beispielsweise eine besondere Ausführungsform des Empfängers 40 vorgesehen. Dieser Empfänger 40 enthält zwei Detektorsysteme I und II sowie eine Auswerteschaltung 99, mit deren Hilfe eine Mehrdeutigkeit beim Überschreiten der Phasenverschiebung von 90° ausgeschlossen werden kann. Der Lichtstrahl der Rückleitung 24 wird über die Auskopplungseinrichtung 36 sowie einen halbdurchlässigen Spiegel 80 sowohl dem Detektorsystem I als auch dem Detektorsystem II zugeführt. Dem Detektorsystem I ist ein $\lambda$/4-Plättchen 82 vorgeschaltet, das den im Falle U=0 linear polarisierten Lichtstrahl zirkular polarisiert. Es enthält einen Strahlteiler 84, beispielsweise ein Wollaston-Prisma, sowie eine Detektorschaltung 86 mit jeweils einem Detektor 88 bzw. 90 für einen der beiden nicht näher bezeichneten Teilstrahlen. Der Detektorschaltung 86 ist ein Differenzverstärker 92 zugeordnet, dessen Ausgangssignal proportional zu der Funktion sin $\delta$ ist, wobei $\delta$ der Winkel der Phasenverschiebung ist, die durch die elektrooptische Doppelbrechung entsteht. Das Detektorsystem II erhält den restlichen Teil des Lichtstrahls nicht über ein $\lambda$/4-Plättchen. Es besteht aus einem Strahlteiler 94 sowie einer Detektorschaltung 96 mit den Detektoren 95 und 97 für die beiden Teilstrahlen und einem nachgeordneten Differenzverstärker 98, dessen Ausgangssignal proportional zu cos $\delta$ ist. Ohne Spannung am Hochspannungsleiter 16, d. h. bei Spannung Null, erhält somit das Detektorsystem II linear polarisiertes und das Detektorsystem I zirkular polarisiertes Licht.

Die zu messende Spannung am Hochspannungsleiter 16 bewirkt die Doppelbrechung mit entsprechender Phasenverschiebung in der Kristallfaser 24, und sowohl der Lichtstrahl im Eingang des Detektorsystems II als auch der Lichtstrahl im Eingang des Systems I werden elliptisch polarisiert. Auf dieser Änderung beruht die Messung im Empfänger 40. Die Auswerteschaltung 99 enthält jeweils einen Multiplikator für die beiden Detektorsysteme I und II sowie eine gemeinsame Einrichtung zur Differenzbildung (oder Summenbildung). Ihr wird außerdem in bekannter Weise von einem Hochfrequenzgenerator 100 eine Trägerfrequenz cos $\omega$t sowie das davon abgeleitete Signal sin $\omega$t zugeführt (»Measuring Current at extra-high Voltage« in Laser Focus, Mai 70, Seiten 35 bis 38). Ein gemeinsamer 1-Generator wie in der bekannten Schaltung ist nicht erforderlich, weil die Signal der Differenzverstärker 92 und 98 bereits proportional zu cos $\delta$ und sin $\delta$ sind. Als Ausgangssignal erhält man am Ausgang 102 des Empfängers 40 ein Signal mit der Zeitabhängigkeit

$$\cos \delta \cos \omega t - \sin \delta \sin \omega t = \cos (\omega t + \delta) \text{ oder}$$
$$\cos \delta \cos \omega t + \sin \delta \sin \omega t = \cos (\omega t - \delta),$$

während am Ausgang 104 die Trägerfrequenz cos $\omega$t abgenommen wird.

Die von der bekannten Anordnung abweichende Ausführungsform der Phasendemodulation mit Hilfe einer Trägerfrequenz in der Auswerteschaltung 99 beruht auf der Erkenntnis, daß bei Intensitätsschwankungen der Teilstrahlen in den Detektorsystemen I und II auch der Generator zur Subtraktion der Konstanten 1 in seiner Intensität entsprechend mit schwanken müßte. Dies ist aber nur mit einem verhältnismäßig großen Aufwand möglich.

Mit Hilfe der Auswerteschaltung 99 wird der als Trägerfrequenz verwendeten hochfrequenten Wechselspannung cos $\omega$t eine Phasenverschiebung aufgeprägt, die mit der optischen Phasenverschiebung $\delta$ in den Kristallfasern übereinstimmt.

Aus der phasenverschobenen Hochfrequenzspannung zwischen den Ausgängen 102 und 104 kann in einer in der Figur nicht dargestellten entfernten Meßwarte die Phasenverschiebung $\delta$ und damit die zu messende Spannung mit Hilfe eines Phasenmessers zurückgewonnen werden.

Wenn die der Phasenmodulation überlagerte Amplitudenmodulation durch Schwankungen der Lichtintensität stört, können die Amplitudenschwankungen in bekannter Weise eliminiert werden (Rev. Sci. Instrum. 44 [1973], Seiten 742—743).

Abweichend von der Ausführungsform des Empfängers 40 nach Fig. 5 kann anstelle der Differenzverstärker 92 und 98 auch jeweils eine analogelektronische Schaltung verwendet werden. Diesen analogelektronischen Schaltungen werden dann die Ausgangssignale der zugeordneten Detektoren 88 und 90 bzw. 95 und 97 zugeführt. Werden die Ausgangssignale der beiden Detektoren 88 und 90 mit $U_1$ bzw. $U_2$ bezeichnet und die Ausgangssignale der Detektoren 95 und 97 mit $U_3$ bzw. $U_4$ bezeichnet, so wird von der betreffenden analogelektronischen Schaltung ein Signal

$$S_1 \sim \frac{U_1 - U_2}{U_1 + U_2} = \sin \delta$$

bzw.

$$S_2 \sim \frac{U_3 - U_4}{U_3 + U_4} = \cos \delta$$

geliefert.

Mit einer besonders vorteilhaften Ausführungsform einer Anordnung zur Spannungsmessung an einem Hochspannungsleiter durch Ausnutzung des elektrooptischen Effekts (Pockels-Effekt) in einer lichtleitenden Kristallfaser erhält man eine Kompensation der Temperaturabhängigkeit des elektrooptischen Effekts der Kristallfasern dadurch, daß nach Fig. 6 als Hin- und Rückleiter verschiedene Fasern derart gegeneinander geschaltet werden, daß sich ihre Temperaturabhängigkeiten bei der Differenzbildung praktisch aufheben. In dieser Ausführungsform sind zwischen dem Sender 2 des Fußteils 1 und dem Kopfteil 20 am Hochspannungsleiter 16 vier Lichtleitfasern hintereinandergeschaltet, von denen die elektrooptisch wirksamen Kristallfasern 124 und 126 als Rückleitungen dienen. Die Zuleitung 114 kann beispielsweise aus einer nicht elektrooptischen Lichtleitfaser bestehen und die Zuleitung 116 wiederum aus einer elektrooptischen Kristallfaser. Dann befinden sich im Kopfteil 20 eine Einkoppeloptik 28 sowie ein Polarisator 26, wie es auch schon in Fig. 5 dargestellt ist. Die erste und zweite Rückleitung 124 bzw. 126 werden nun mit der zweiten Zuleitung 116 durch die Auswahl zwei verschiedener optisch wirksamer Materialien so kombiniert, daß sich ihre Beiträge zur Temperaturabhängigkeit des Meßsignals wenigstens annähernd aufheben.

Diese Ausführungsform beruht auf der Erkenntnis, daß der elektrooptische Koeffizient $r_{63}$ dem Curie-Weiß-Gesetz unterliegt, das zur Abnahme des Meßsignals mit zunehmender Temperatur führt, wobei verschiedene Materialien verschiedene Temperaturkoeffizienten besitzen. Die Aufgabe, den Spannungswandler so zu gestalten, daß die Temperaturabhängigkeit wenigstens nahezu aufgehoben ist, wird nun dadurch gelöst, daß beispielsweise als erste Rückleitung 124 und als zweite Zuleitung 116 jeweils eine Kristallfaser mit starkem elektrooptischem Effekt und einer gewissen Temperaturabhängigkeit verwendet wird. Als zweite Rückleitung 126 wird dann eine Kristallfaser mit nicht wesentlich stärkerem elektrooptischem Effekt, aber wesentlich stärkerer Temperaturabhängigkeit verwendet. Koppelt man diese Fasern so, daß sich der elektrooptische Effekt der Faser 126 von der Summe der elektrooptischen Effekte der Fasern 124 und 116 subtrahiert, so heben sich nicht die elektrooptischen Effekte, jedoch die Temperaturabhängigkeiten der Kristallfasern wenigstens annähernd auf.

Zwischen der Zuleitung 114 und der Rückleitung 124 im Kopfteil 20 wird lediglich ein einfacher in der Figur nicht dargestellter Umlenkkörper verwendet. Zwischen der Rückleitung 124 und der Zuleitung 116 ist dann eine Kupplungseinrichtung 128 erforderlich, damit sich die elektrooptischen Effekte über die Leitungswege summieren. Die Änderung der kristallographischen Orientierung der Faserkristalle ist durch zwei unterschiedliche Tetraeder 130 und 132 angedeutet. Am Ende der ersten Rückleitung 124 und der zweiten Zuleitung 116 ist im Fußteil 2 bzw. im Kopfteil 20 ein Umlenkkörper vorgesehen, wie er beispielsweise in Fig. 1 dargestellt ist. Diese Umlenkkörper bewirken eine Krümmung des Faserkristalls mit zwei Viertelwindungen in der senkrechten Ebene und einer Halbwindung in der waagerechten Ebene und kompensieren dadurch die krümmungsbedingte Doppelbrechung. Am Anfang der zweiten Rückleitung 126 ist dann wiederum eine Kopplungseinrichtung 134 vorgesehen. Die Beziehung der kristallographischen Orientierung der beiden Fasern aus verschiedenem Material ist durch die beiden Tetraeder 136 und 138 angedeutet. Die Phasendemodulationsschaltung im Empfänger 40 kann beispielsweise in gleicher Weise aufgebaut sein, wie es in Fig. 5 dargestellt ist.

Für Kaliumdihydrogenphosphat $KH_2PO_4$, das in der folgenden Beschreibung mit KDP bezeichnet werden soll, beträgt beispielsweise der elektrooptische Koeffizient

$$r_{63} = -\frac{1}{3}\left(1,0 + \frac{5400}{151+T/°C}\right) \text{ pm/V}$$

(Landolt-Börnstein, Neue Serie, Gruppe III, Band 1, Seite 144). Für Ammoniumdihydrogenphosphat $(NH_4)H_2PO_4$, das in der folgenden Beschreibung mit ADP bezeichnet werden soll, beträgt der elektrooptische Koeffizient

$$r_{63} = \frac{1}{3}\left(6,14 - \frac{10800}{317+T/°C}\right) \text{ pm/V}.$$

Daraus ergeben sich bei 18°C die Temperaturkoeffizienten

$$\frac{1}{r}\frac{dr}{dT} = 5,74 \cdot 10^{-3}K^{-1} \text{ für KDP und}$$

$$3,69 \cdot 10^{-3}K^{-1} \text{ für ADP.}$$

Verwendet man in dem Ausführungsbeispiel nach Figur 6 eine nicht elektrooptische Zuleitung 114, eine KDP-Kristallfaser als zweite Rückleitung 126 sowie zwei ADP-Kristallfasern als 1. Rückleitung 124 und 2. Zuleitung 116 und orientiert man die Fasern an den Kopplungsstellen derart, daß die resultierende Phasendifferenz

$$\delta = \frac{2\pi}{\lambda} U (2 n_{ADP}^3 r_{ADP} - n_{KDP}^3 r_{KDP})$$

beträgt, so ist der Temperaturkoeffizient dieser Phasendifferenz bei Vernachlässigung der Temperaturkoeffizienten der Brechungsindices nur

$$\frac{d\delta}{\delta\, dT} = \frac{2 n_{ADP}^3 dr_{ADP}/dT - n_{KDP}^3 dr_{KDP}/dT}{2 n_{ADP}^3 r_{ADP} - n_{KDP}^3 r_{KDP}}$$

$$= \frac{2 \cdot 0,112 - 0,217}{2 \cdot 30,5 - 37,8} K^{-1} = 3,0 \cdot 10^{-4}K^{-1}.$$

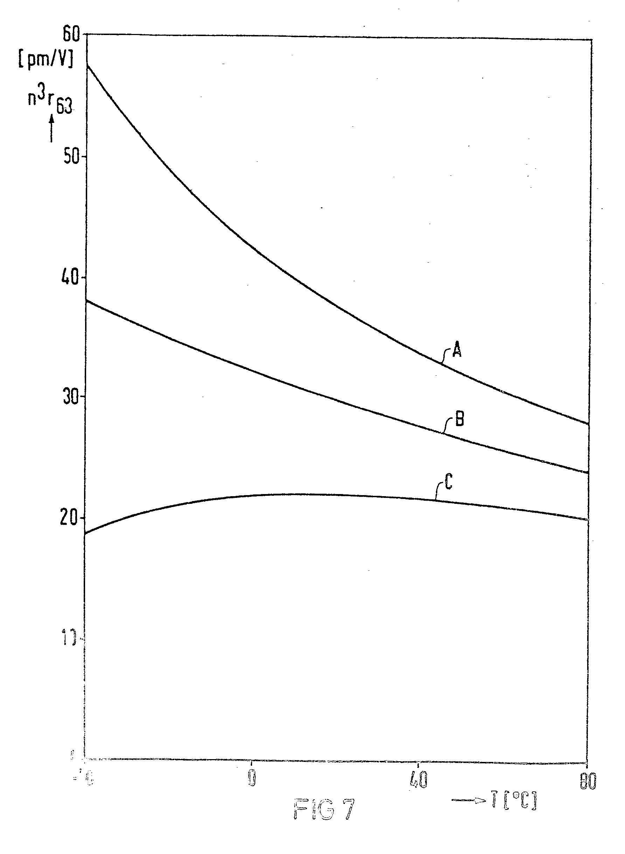

Das Diagramm nach Fig. 7, in dem auf der Ordinate der Ausdruck $n^3 r_{63}$ der verwendeten Materialien in pm/V und auf der Abszisse die Temperatur T in °C aufgetragen ist, zeigt den Verlauf der Kennlinie für $n_{KDP}^3 r_{KDP}$ mit A und $n_{ADP}^3 r_{ADP}$ mit B und die Kombination der beiden Kennlinien aus zwei ADP-Fasern und einer KDP-Faser mit C. Die Gegeneinanderschaltung der Faserkristalle nach Fig. 6 ergibt den Verlauf der Kurve C. Die Temperaturabhängigkeit der Größe $n^3 r_{63}$, welche die elektrooptische Doppelbrechung der Faserkristalle bestimmt, ist somit in der Anordnung nach Fig. 6 nahezu aufgehoben.

Durch die Kombination einer Faser des Materials der Kennlinie A mit starker Temperaturabhängigkeit und einem gewissen elektrooptischen Effekt mit zwei Fasern des Materials der Kennlinie B mit nur wenig schwächerem elektrooptischem Effekt aber etwa halb so starker Temperaturabhängigkeit, erhält man somit für die gesamte Hintereinanderschaltung der Kristallfasern die Kennlinie C, bei sich zwar wenigstens annähernd die Temperaturabhängigkeiten, jedoch nicht die elektrooptischen Effekte aufheben.

Neben der Möglichkeit, den Temperaturkoeffizienten der elektrooptischen Doppelbrechung mit einer Anordnung nach Fig. 6 zu kompensieren, gibt es auch die Möglichkeit, bereits mit einer Hinleitung und einer Rückleitung eine Kompensation der Temperaturabhängigkeit zu erreichen. Ordnet man z. B. bei einer Anordnung der Kristallfasern nach Fig. 1 mit einem Empfänger nach Fig. 5 zwei Kristallfasern aus verschiedenen Materialien im Gegensatz zu Fig. 1 so an, daß sich ihre elektrooptisch erzeugten Phasenverschiebungen subtrahieren, so ist das Meßsignal am Ausgang 42 des Empfängers 40 proportional der Größe $n^3 r - n'^3 r'$, wobei n und n' die ordentlichen Brechungsindices der beiden verschiedenen Materialien ohne elektrische Spannung und r bzw. r' die elektrooptischen Koeffizienten $r_{63}$ der beiden verschiedenen Faserkristalle sind. Der Temperatur-Koeffizient des Meßsignals beträgt dann

7

$$\frac{1}{S}\frac{dS}{dT} = \frac{n^3 dr/dT - n'^{\,3}dr'/dT}{n^3 r - n'^3 r'}.$$

Für diese Ausführungsform eignet sich somit ein Materialpaar, für das der Zähler in der rechten Seite dieser Gleichung möglichst klein ist, nicht dagegen der Nenner.

In einer weiteren Ausführungsform der Anordnung zur elektrooptischen Spannungsmessung mit einem Kompensator nach Fig. 1 müssen die verwendeten Kristallfasern und der Kompensator sowieso aus verschiedenen elektrooptisch wirksamen Materialien bestehen. In diesem Fall erhält man als Meßsignal eine Spannung

$$U' = U \cdot \frac{n^3 r}{n'^{\,3}r'},$$

wenn auch im Kompensator ein longitudinaler elektrooptischer Effekt ausgenutzt wird. U ist darin die zu messende Spannung an der Hochspannungsleitung. Vernachlässigt man wieder die Temperaturabhängigkeit der Brechungsindices, so beträgt der Temperaturkoeffizient des Meßsignals in diesem Fall

$$\frac{1}{U'}\frac{dU'}{dT} = \frac{1}{r}\frac{dr}{dT} - \frac{1}{r'}\frac{dr'}{dT}.$$

Wenn das Meßsignal wesentlich kleiner als die zu messende Spannung sein soll, eignen sich für diese Ausführungsform Materialien mit sehr unterschiedlichen Werten von $n^3 r$ aber nahezu gleichem Temperaturkoeffizienten des elektrooptischen Effektes.

Außerdem ist zur Kompensation der Temperaturabhängigkeit auch eine Ausführungsform mit zwei verschiedenen Kristallfasern (n, r bzw. n', r') und einem Kompensator (n'', r'') entsprechend Fig. 1 möglich. In diesem Fall beträgt das Meßsignal

$$U' = U\,\frac{n^3 r \pm n'^{\,3}r'}{n''^{\,3}r''}$$

und sein Temperaturkoeffizient

$$\frac{1}{U'}\frac{dU'}{dT} = \frac{n^3 dr/dT \pm n'^{\,3}dr'/dT}{n^3 r \pm n'^3 r'} - \frac{1}{r''}\frac{dr''}{dT},$$

wobei die beiden Vorzeichen für die beiden möglichen Kristallorientierungen der Kristallfasern zueinander an der Kopplungsstelle gelten. Diese Ausführungsform ist vorzugsweise geeignet für Materialkombinationen, bei denen der Temperaturkoeffizient besonders klein ist.

Neben der Ausführungsform nach Fig. 6 mit doppelter Zu- und Rückleitung ergeben sich weitere Ausführungsformen dadurch, daß man den Lichtstrahl des Senders 2 auch mehr als zweimal zur Hochspannung am Kopfteil 20 und zurück zum Fußteil 1 führen kann und auch mehr als zwei verschiedene Fasermaterialien miteinander kombinieren kann, wenn die für die Fasermaterialien geltenden Temperaturkoeffizienten sich auf diese Weise kompensieren.

Im Ausführungsbeispiel nach Fig. 1 ist ein Umlenkkörper 30 vorgesehen, durch dessen Gestaltungsform eine zusätzliche Doppelbrechung durch die Krümmung der Kristallfaser 14 verhindert wird. Man kann aber auch die Einführung einer zusätzlichen Doppelbrechung in die Kristallfaser 14 durch die Krümmung im Kopfteil 20 am Hochspannungsleiter 16 zulassen und diese konstante Doppelbrechung dann im Empfänger 40 kompensieren.

## Patentansprüche

1. Anordnung zur elektrooptischen Spannungsmessung an einem Hochspannungsleiter, dessen elektrisches Feld einen linear oder zirkular polarisierten Lichtstrahl elliptisch polarisiert und bei der in einem Empfänger die zu messende Spannung aus der Phasendifferenz zwischen den mit verschiedenen Durchtrittsgeschwindigkeiten laufenden Komponenten der Lichtwelle abgeleitet wird, mit Leitungen für den polarisierten Lichtstrahl zwischen einem Kopfteil mit dem Hochspannungsleiter und einem Fußteil mit einem Sender und dem Empfänger, dadurch gekennzeichnet, daß als Leitungen (14, 24) für den polarisierten Lichtstrahl (4) zwischen dem Kopfteil (20) mit dem Hochspannungsleiter (16) und dem Fußteil (1) mit dem Sender (2) und dem Empfänger (40) wenigstens zwei Kristallfasern mit longitudinalem, linearem elektrooptischen Effekt vorgesehen sind, wobei jeweils zwei auf dem Weg des Lichtstrahls (4) aufeinanderfolgende Faserenden fluchten und wobei die Kristallorientierungen von jeweils zwei auf dem Weg des Lichtstrahls (4) aufeinanderfolgenden Kristallfasern gegeneinander um 90° gedreht sind.

2. Anordnung nach Anspruch 1, dadurch gekennzeichnet, daß die im Kopfteil (20) gekrümmte Kristallfaser am Hochspannungsleiter (16) derart in Teilwindungen (21, 22, 23) geführt ist, daß die Formdoppelbrechung innerhalb des Fasermaterials aufgehoben ist (Fig. 1).

3. Anordnung nach Anspruch 1 oder 2, dadurch gekennzeichnet, daß am Hochspannungsleiter (16) ein Umlenkkörper (30) zur Führung der Kristallfaser in Teilwindungen (21, 22, 23) hintereinander in zueinander senkrechten Ebenen vorgesehen ist.

4. Anordnung nach einem der Ansprüche 1 bis 3, dadurch gekennzeichnet, daß der Zuleitung (14) ein $\lambda/4$-Plättchen vorgeschaltet ist.

5. Anordnung zur elektrooptischen Spannungsmessung an einem Hochspannungsleiter, dessen elektrisches Feld einen linear oder zirkular polarisierten Lichtstrahl elliptisch polarisiert und bei der in einem Empfänger die zu messende Spannung aus der Phasendifferenz zwischen den mit verschiedenen Durchtrittsgeschwindigkeiten laufenden Komponenten der Lichtwelle abgeleitet wird, mit Leitungen für den polarisierten Lichtstrahl zwischen einem Kopfteil mit dem Hochspannungsleiter und einem Fußteil mit einem Sender und einem Empfänger, dadurch gekennzeichnet, daß als Leitungen für den polarisierten Lichtstrahl (4) zwischen dem Kopfteil (20) mit dem Hochspannungsleiter (16) und dem Fußteil (1) mit dem Sender (2) und dem Empfänger (40) wenigstens eine Kristallfaser mit longitudinalem, linearem elektrooptischen Effekt und wenigstens eine nicht elektrooptisch wirksame Lichtleitfaser vorgesehen sind.

6. Anordnung nach Anspruch 5, dadurch gekennzeichnet, daß als Zuleitung eine nicht elektrooptisch wirksame Kristallfaser vorgesehen ist und der Rückleitung (24) im Kopfteil (20) auf der Hochspannungsseite ein Polarisator (26) und ein $\lambda/4$-Plättchen vorgeschaltet ist.

7. Anordnung nach einem der Ansprüche 1 bis 6, dadurch gekennzeichnet, daß der Empfänger (40) einen Kompensator (38) enthält, dessen Ausgangssignal als Maß für die zu messende Spannung vorgesehen ist.

8. Anordnung nach einem der Ansprüche 1 bis 3, dadurch gekennzeichnet, daß zur Phasendemodulation im Empfänger (40) zwei Detektorsysteme (I, II) vorgesehen sind, von denen einem Detektorsystem (I) ein $\lambda/4$-Plättchen (82) vorgeschaltet ist und die jeweils ein Strahlteilerprisma (84 bzw. 94) und den Teilstrahlen zugeordnete Detektoren (88, 90 bzw. 95, 97) enthalten und die ferner jeweils einen Differenzverstärker (92 bzw. 98) und einen nachgeordneten Trägerfrequenzmodulator (Multiplikator) enthalten, dem ein Hochfrequenzgenerator (100) für eine Trägerfrequenz zugeordnet ist und daß eine gemeinsame Auswerteschaltung (99) zur Differenz- oder Summenbildung aus den Produkten vorgesehen ist (Fig. 5).

9. Anordnung nach Anspruch 8, dadurch gekennzeichnet, daß das Strahlteilerprisma (84) des ersten Detektorsystems (I) so orientiert ist, daß das Ausgangssignal des Differenzverstärkers (92) proportional zu sin $\delta$ ist, daß das Strahlteilerprisma (94) des zweiten Detektorsystems (II) so orientiert ist, daß das Ausgangssignal des Differenzverstärkers (98) proportional zu cos $\delta$ ist, mit der der zu messenden Spannung proportionalen Phasenverschiebung $\delta$ der elektrooptischen Doppelbrechung.

10. Anordnung nach Anspruch 1 bis 4, 8 oder 9, dadurch gekennzeichnet, daß die Zuleitung und die Rückleitung aus derart verschiedenen elektrooptisch wirksamen Materialien bestehen, daß sich ihre Temperaturabhängigkeiten wenigstens annähernd kompensieren.

11. Anordnung nach Anspruch 7, dadurch gekennzeichnet, daß die Kristallfasern der Zuleitung und/oder der Rückleitung und das Kristallmaterial des Kompensators (36) aus derart verschiedenen elektrooptisch wirksamen Materialien bestehen, daß sich ihre Temperaturabhängigkeiten wenigstens annähernd kompensieren.

12. Anordnung nach einem der Ansprüche 1 bis 9, dadurch gekennzeichnet, daß mehrere Zuleitungen (114, 116) mit jeweils einer Rückleitung (124 bzw. 126) aus mindestens zwei verschiedenen elektrooptischen Materialien hintereinander angeordnet und kristallographisch so orientiert sind, daß sich die Temperaturkoeffizienten der elektrooptischen Effekte wenigstens annähernd kompensieren (Fig. 6).

13. Anordnung nach Anspruch 12, dadurch gekennzeichnet, daß die erste Zuleitung (114) aus einem elektrooptisch unwirksamen Lichtleiter besteht, und daß von den drei übrigen Kristallfasern (124, 116 und 126) zwei aus Ammoniumdihydrogenphosphat und eine aus Kaliumdihydrogenphosphat bestehen und kristallographisch so orientiert hintereinander gekoppelt sind, daß sich die Temperaturkoeffizienten der elektrooptischen Effekte wenigstens annähernd kompensieren.

## Claims

1. An arrangement for the electro-optical measurement of voltage on a high-voltage conductor whose electric field elliptically polarises a linearly or circularly polarised light beam and wherein the voltage to be measured is derived in a receiver from the phase difference between components of the light wave passing through at different rates, comprising lines for the polarised light beam between a head member having the high-voltage conductor and a base member having a transmitter and the receiver, characterised in that between the head member (20) having the high-voltage conductor (16) and the base member (1) having the transmitter (2) and the receiver (40) there are arranged as lines (14, 24) for the polarised light beam (4) at least two crystal fibres which have a longitudinal, linear, electro-optical effect, wherein in each case two fibre ends which succeed one another on the path of the light beam (4) are in alignment and wherein the crystal orientations of in each case two crystal fibres which suceed one another on the path of the light beam (4) are mutually rotated by 90°.

2. An arrangement as claimed in claim 1, characterised in that the crystal fibres which are wound on the head member (20) are guided on the high-voltage conductor (16) in partial windings (21, 22, 23) in such manner that the double refraction formed within the fibre material is eliminated (Fig. 1).

3. An arrangement as claimed in claim 1 or 2, characterised in that a guide body (30) is arranged on the high-voltage conductor (16) in order to consecutively guide the crystal fibre in partial windings (21, 22, 23) in planes which are mutually perpendicular.

4. An arrangement as claimed in one of claims 1 to 3, characterised in that a $\lambda/4$ plate is connected preceding the supply line (14).

5. An arrangement for the electro-optical measurement of voltage on a high-voltage conductor whose electric field elliptically polarises a linearly or circularly polarised light beam and wherein the voltage to be measured is derived in a receiver from the phase difference between the components of the light wave passing through at different rates, comprising lines for the polarised light beam between a head member having the high-voltage conductor and a base member having a transmitter and a receiver, characterised in that between the head member (20) having the high-voltage conductor (16) and the base member (1) having the transmitter (2) and the receiver (40) there are arranged at least one crystal fibre having a longitudinal linear electro-optical effect and at least one light-conductor fibre that is not electro-optically active.

6. An arrangement as claimed in claim 5, characterised in that a crystal fibre which is not electro-optically active is provided as a supply line and a polariser (26) and a $\lambda/4$ plate are connected in the head member (20) on the high-voltage side preceding the return line (24).

7. An arrangement as claimed in one of claims 1 to 6 characterised in that the receiver (40) comprises a compensator (38) whose output signal is provided as a measure of the voltage to be measured.

8. An arrangement as claimed in one of claims 1 to 3 characterised in that in the receiver (40) there are arranged two detector systems (I, II) for the phase demodulation, of which one detector system (I) is preceded by a $\lambda/4$ plate (82), and which respectively contain a beam divider prism (84 and 94) and detectors (88, 90 and 95, 97) assigned to the partial beams, and which further respectively contain a difference amplifier (92 and 98) and a following carrier frequency modulator (multiplier) to which a high frequency generator (100) for a carrier frequency is assigned, and that a common analysis circuit (99) for the difference formation or sum formation from the products is provided (Fig. 5).

9. An arrangement as claimed in claim 8, characterised in that the beam dividing prism (84) of the first detector system (I) is so orientated that the output signal of the difference amplifier (92) is proportional to $\sin \delta$, that the beam dividing prism (94) of the second detector system (II) is so orientated, and that the output signal of the difference amplifier (98) is proportional to $\cos \delta$, where $\delta$ is the phase shift of the electro-optical double refraction which is proportional to the voltage to be measured.

10. An arrangement as claimed in claim 1 to 4, 8 or 9, characterised in that the supply line and the return line consist of electro-optically active materials which are so different that their temperature dependencies at least approximately compensate one another.

11. An arrangement as claimed in claim 7, characterised in that the crystal fibres of the supply line and/or of the return line and the crystal material of the compensator (36) consist of electro-optically active materials which are so different that their temperature dependencies at least approximately compensate one another.

12. An arrangement as claimed in one of claims 1 to 9, characterised in that a plurality of supply lines (114, 116) which respectively have a return line (124 and 126) made of at least two different electro-optically active materials are consecutively arranged and crystallographically so orientated that the temperature coefficients of the electro-optical effects at least approximately compensate one another (Fig. 6).

13. An arrangement as claimed in claim 12, characterised in that the first supply line (115) consists of an electro-optically inactive light-conductor, and that of the three remaining crystal fibres (124, 116 and 126), two consist of ammonium dihydrogen phosphate and one consists of potassium dihydrogen phosphate and are crystallographically so orientated and consecutively coupled that the temperature coefficients of the electro-optical effects at least approximately compensate one another.

## Revendications

1. Dispositif pour la mesure électro-optique de la tension d'un conducteur haute tension, dont le champ électrique polarise elliptiquement un rayon lumineux polarisé linéairement ou circulairement, et dans lequel on déduit, dans un récepteur, la tension à mesurer à partir de la différence de phase entre les composantes de l'onde lumineuse qui se déplacent avec des vitesses de passage différentes, avec des conducteurs pour le rayon limineux polarisé entre une partie supérieure contenant le conducteur haute tension et une partie inférieure contenant un émetteur et le récepteur, caractérisé par le fait que l'on prévoit comme conducteurs (14, 24) pour le rayon lumineux polarisé (4), entre la partie supérieure (20) contenant le conducteur haute tension (16) et la partie inférieure (1) contenant l'émetteur (2) et le récepteur (40), au moins des fibres de cristaux à effet électro-optique longitudinal et linéaire, deux extrémités de fibres qui se suivent en direction de la trajectoire du rayon lumineux (4) étant alignées et les orientations des cristaux des deux fibres de cristaux qui se suivent dans la trajectoire du rayon lumineux (4) étant décalées entre elles de 90°.

2. Dispositif selon la revendication 1, caractérisé par le fait que les fibres de cristaux qui sont courbées dans la partie supérieure (20) sont guidées, au niveau du conducteur haute tension (16) de telle manière suivant des spires partielles (21, 22, 23) que la double réfraction de forme à l'intérieur du matériau constitutif des fibres est supprimée (figure 1).

3. Dispositif selon la revendication 1 ou 2, caractérisé par le fait qu'il est prévu au niveau du conducteur haute tension (16) un corps de renvoi (13) pour le guidage de la fibre de cristaux suivant des spires partielles (21, 22, 23) disposées les unes derrière les autres et suivant des plans qui sont perpendiculaires entre eux.

4. Dispositif selon l'une des revendications 1 à 3, caractérisé par le fait qu'en amont du guide d'amenée (14) est prévue une lamelle ($\lambda/4$).

5. Dispositif pour la mesure électro-optique de la tension d'un conducteur haute tension, dont le champ électrique polarise elliptiquement un rayon lumineux polarisé linéairement ou circulairement, et dans lequel on déduit, dans un récepteur, la tension à mesurer à partir de la différence de phase entre les composantes de l'onde lumineuse qui se déplacent avec des vitesses de passage différentes, avec des conducteurs pour le rayon lumineux polarisé entre une partie supérieure contenant le conducteur haute tension et une partie inférieure contenant un émetteur et le récepteur, caractérisé par le fait que l'on prévoit comme guides pour le rayon lumineux polarisé (4), entre la partie supérieure (20) comportant le conducteur haute tension (16) et la partie inférieure (1) comportant l'émetteur (2) et le récepteur (40), au moins une fibre de cristaux à effet électro-optique longitudinal et linéaire et au moins une fibre optique n'agissant pas par effet électro-optique.

6. Dispositif selon la revendication 5, caractérisé par le fait que l'on prévoit comme guides d'amenée une fibre de cristaux sans effet électro-optique et par le fait que l'on dispose en amont du guide de retour (24), dans la partie supérieure (20), du côté haute tension, un polariseur (26) et une lamelle ($\lambda/4$).

7. Dispositif selon l'une des revendications 1 à 6, caractérisé par le fait que le récepteur (40) comporte un compensateur (38) dont le signal de sortie est prévu pour la tension à mesurer.

8. Dispositif selon l'une des revendications 1 à 3, caractérisé par le fait que pour la démodulation de phase, il est prévu dans le récepteur (40) deux systèmes de détection (I, II) parmi lesquels une lamelle ($\lambda/4$) (82) est montée en amont d'un système de détection (I), et qui contiennent respectivement un prisme diviseur de rayons (84, 94) et des détecteurs (88, 90 et 95, 97) associés aux rayons partiels et qui comportent en outre respectivement un amplificateur différentiel (92 et 98) et un modulateur de fréquences porteuses (multiplicateur) monté en aval et auquel est associé un générateur haute fréquence (100) pour une fréquence porteuse, et par le fait qu'il est prévu un circuit d'évaluation commun (99) pour former la différence ou la somme à partir des produits (figure 5).

9. Dispositif selon la revendication 8, caractérisé par le fait que le prisme diviseur de rayons (84) du premier système de détection (I) est orienté de telle façon que le signal de sortie de l'amplificateur différentiel (92) est proportionnel à sin $\delta$, que le prisme diviseur de rayons (94) du second système de détection (II) est orienté de telle façon que le signal de sortie de l'amplificateur différentiel (98) est proportionnel à cos $\delta$, avec le déphasage $\delta$ de la double réfraction électro-optique, qui est proportionnel à la tension à mesurer.

10. Dispositif selon la revendication 1 à 4, 8 ou 9, caractérisé par le fait que le guide d'amenée et le guide de retour sont constitués avec des matériaux à effet électro-optique différents de telle façon que leurs dépendances à la température se compensent au moins approximativement.

11. Dispositif selon la revendication 7, caractérisé par le fait que les fibres de cristaux du guide d'amenée et/ou du guide de retour et le matériau de cristal du compensateur (36) sont constitués avec des matériaux à effet électro-optique différents au point que leurs dépendances à la température se compense au moins approximativement.

12. Dispositif selon l'une des revendications 1 à 9, caractérisé par le fait que plusieurs guides d'amenée (114, 116) sont montés l'un derrière l'autre avec respectivement un guide de retour (124, 126) en au moins deux matériaux électro-optiquement différents et sont orientés du point de vue cristallographique de telle façon que les coefficients de températures des effets électro-optiques se compensent au moins approximativement (figure 6).

13. Dispositif selon la revendication 12, caractérisé par le fait que le premier guide d'amenée (114) est constitué par un guide d'onde de lumière inefficace du point de vue électro-optique et que parmi les trois autres fibres de cristaux (124, 116 et 126) deux sont constituées par du phosphate monoammonique et une avec du phosphate monopotassique et sont couplées successivement avec une orientation cristallographique telle que les coefficients de température des effets électro-optiques se compensent au moins approximativement.

FIG 1

FIG 3
U<0

FIG 2
U=0

FIG 4
U>0

0 011 110

FIG 5

FIG 6

FIG 7